# EUROPEAN PATENT APPLICATION

(11) **EP 4 664 115 A1**
(43) Date of publication of application: **17.12.2025**
(21) Application number: 24425029.6
(22) Date of filing: 11.06.2024
(51) Int. Cl.: G01R 1/04, G01R 31/28

(54) **BURN-IN TEST APPARATUS ARRANGED FOR HIGH-VOLTAGE AND LOW-VOLTAGE TESTS**

(71) Applicant: Microtest S.p.A., 56010 Vicopisano (PI) (IT)
(72) Inventor: AMELIO, Giuseppe, 55100 San Pietro (LU) (IT)
(74) Representative: Botti & Ferrari S.p.A.

(57) **Abstract**

Burn-in apparatus comprising at least one rack and a plurality of chambers to receive a respective plurality of wafers to be tested, each one housed on a dedicated BID (5), wherein each chamber comprises a contact device (400) which is capable of contacting said BID (5), said contact device (400) comprising a first contact plate (404), provided with electrical contacts for high-voltage tests (404'), which are capable of contacting first electrical contacts (51) of said BID (5) and a second contact plate (405), provided with electrical contacts for low-voltage tests (405'), which are capable of contacting second electrical contacts (52) of said BID (5)

## Description

### Field of application

The present invention relates to a burn-in test apparatus, in particular an apparatus to carry out burn-in tests on integrated electronic circuits directly at a wafer level.

Said apparatuses are used in the production phase of integrated electronic circuits to identify and discard any defective circuit directly at a wafer level.

In this type of test the devices, i.e. the single chips, are hence still joined in groups: this assembly of devices is precisely called wafer.

In the subsequent steps of the production and qualification process, the devices will be divided and undergo the packaging process. The apparatus according to the present invention is thus used to carry out electrical wafer-level burn-in tests, whose aim is to select the devices produced by identifying those which, due to internal defects, are destined to early break ("infant mortality" phenomenon). Carrying out said tests before finishing the division and packaging process allows cost savings.

More particularly, the invention relates to a burn-in test apparatus which is able to carry out both high-voltage and low-voltage tests in a same chamber or slot.

### Prior art

In the field of the invention, it is known to use cartridges into which the single wafers to be tested are loaded before the burn-in test. Said cartridges are introduced into suitable chambers of a test apparatus, wherein they electrically connect to a test board intended to send test signals to the single devices which are on the wafer.

To carry out burn-in tests, the apparatus comprises a heating system intended to bring the devices to a desired temperature to simulate a thermal stress.

The chambers of the test apparatus have therein a circuitry with end contacts arranged to carry out different types of tests. In particular, said tests can be high-voltage or low-voltage ones.

On the other hand, in order to be able to carry out both tests the circuitries and contacts must be sized to withstand the maximum applied voltage, with subsequent oversizing in the case of all low-voltage applications.

The technical problem underlying the present invention is hence to solve the above-reported drawbacks of the prior art, providing an apparatus which allows to carry out both low-voltage and high-voltage wafer-level burn-in tests, with a reduced energy expenditure and with component costs being as low as possible.

### Summary of the invention

The solution idea underlying the present invention is to manufacture a burn-in apparatus in which, in a single chamber, it is possible to carry out low-voltage and high-voltage tests by using different circuitries and contacts which respectively interface with the opposed BID faces.

The above-identified technical problem is solved by a burn-in apparatus comprising at least one chamber to receive a wafer to be tested, housed on a dedicated burn-in driver - BID, said chamber comprising a contact device which is capable of contacting said BID, characterized in that said contact device comprises a first contact plate, provided with electrical contacts for high-voltage tests, which are capable of contacting first electrical contacts of said BID and a second contact plate, provided with electrical contacts for low-voltage tests, which are capable of contacting second electrical contacts of said BID.

In this way, the electrical contacts and the related high-voltage circuits are confined to a single area of the chamber, and they must not comprise components solely required for low-voltage tests.

Preferably, said first contact plate is positioned above with respect to said chamber and said second contact plate is positioned below with respect to said chamber, or vice versa.

The respective circuitries are thus located on the top and on the bottom of the chamber which houses the BID.

Preferably, said contact device comprises an intermediate housing, which is capable of integrally housing said BID, and displacement means for moving said intermediate housing along a vertical axis, so as to put said first electrical contacts or said second electrical contacts of said BID in contact with said high-voltage electrical contacts or said low-voltage electrical contacts respectively.

In other words, the intermediate housing is a floating component which can vertically move bringing the BID in contact with the top or the bottom of the chamber respectively, so as to be capable of interfacing with the different connectors dedicated to low-voltage tests and high-voltage tests respectively.

Preferably, the displacement means consist of at least one first actuator and at least one second actuator which act at the opposed lateral edges of the intermediate housing, so as not to interfere with the electrical connections which occupy the central area.

Still preferably, a pair of first actuators, arranged above and below with respect to the intermediate housing, and a pair of second actuators, arranged above and below with respect to the intermediate housing, are provided.

This configuration allows a stable and precise vertical movement.

Preferably, the first and second actuators are linear actuators, arranged to rotate one or more cams mounted idle on the intermediate housing, said cams coupling with the first and/or second contact plate, or with elements which are integral therewith, to promote the vertical movement of the intermediate housing by virtue of its rotation.

Specifically, said cams can be made on idle cylinders mounted with a vertical axis, and they can be connected to the actuators with a crank gear or other system adapted to convert a translational motion into a rotary motion, for example a rack.

Preferably, said first and second actuators are hydraulic or pneumatic linear actuators.

Preferably, the electrical contacts for high-voltage tests and the electrical contacts for low-voltage tests are compliant contacts, particularly pogo-pins.

On the contrary, the first electrical contacts and the second electrical contacts are preferably fixed contacts, i.e. contact pads which are devoid of elastic components.

Preferably, the first electrical contacts and the second electrical contacts are respectively made on an upper surface and on a lower surface of said BID, or vice versa.

Always preferably, the first electrical contacts and the second electrical contacts are made in a rear BID portion, a front BID portion supporting instead a shell for housing the wafer to be tested.

Said BID can thus comprise electrical connections which connect the first electrical contacts and the second electrical contacts to respective pads of the wafer to be tested housed in said shell, so as to allow the signal transmission from the test machine to the wafer.

Preferably, said BID can be extracted with respect to the chamber according to a posterior-anterior direction.

The burn-in apparatus is preferably of the type comprising a rack equipped with a plurality of stacked chambers.

In a preferred embodiment, the shell which houses the wafer integrates therein a heater acting on the wafer itself. The heater can thus be brought in direct contact with the wafer to be tested, minimizing the thermal dispersions and allowing a significant energy saving. It is thus not necessary to provide fixed heating means inside the rack of the burn-in apparatus.

A technology without a main oven of the test machine, or anyway without a heat source outside the shell, is so obtained.

Preferably, the shell is also equipped with autonomous cooling means and sealing means of its own housing compartment of the wafer to be tested.

The features and advantages of the burn-in apparatus according to the present invention will be apparent from the description of the following exemplary embodiments given by way of non-limiting examples with reference to the attached drawings.

### Brief description of the drawings

Figure 1 shows a perspective view of a burn-in apparatus with a rack, according to the present invention;
Figure 2 shows a perspective view of the burn-in apparatus of figure 1;
Figure 3 shows a perspective view of the burn-in apparatus of figure 1, in which the BIDs containing the wafers to be tested are visible;
Figure 4 shows a perspective view of a device inside said burn-in apparatus, in an extracted-BID configuration;
Figure 5 shows a perspective view of a device inside said burn-in apparatus, in an inserted-BID configuration;
Figure 6 shows a lateral schematic sectional view of the device shown in Figure 4 with extracted BID;
Figure 7 shows a perspective view of the device shown in Figure 6;
Figure 8 shows a perspective view of the device with inserted BID;
Figures 9a-9c show a lateral schematic sectional view of the device shown in Figure 4 with inserted BID, BID with high-voltage contact and BID with low-voltage contact respectively;
Figure 10 shows a schematic sectional view of an embodiment of the shell of the apparatus according to the present invention in an configuration with a wafer interposed between the base and the cover.

### Detailed description

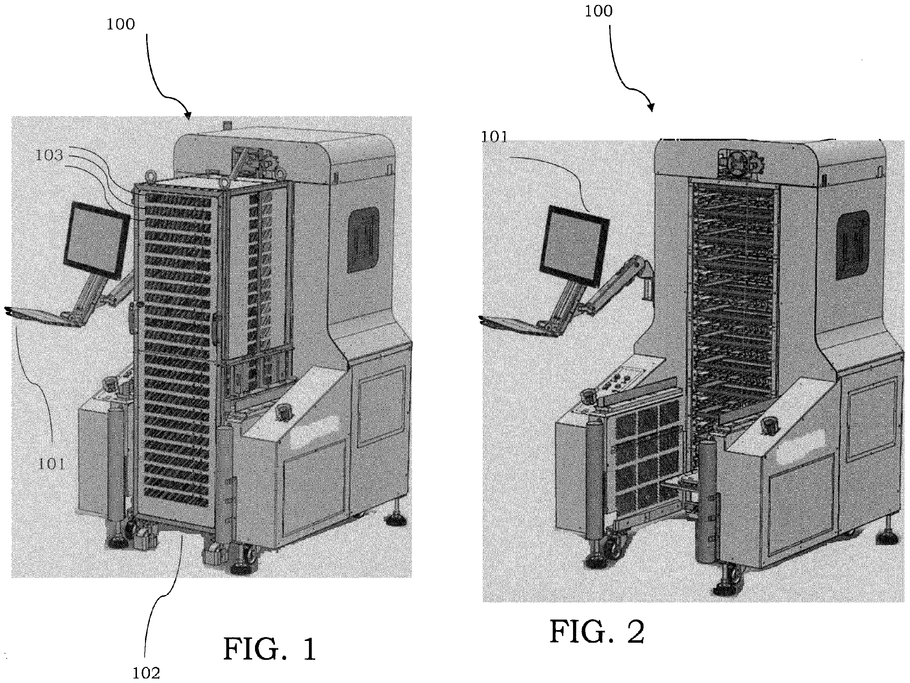

With reference to figure 1 of the attached drawings, a burn-in apparatus, identified herebelow with the acronym BIS - *Burn-in Socket,* is indicated with 100, comprising a user interface 101 and arranged to house at least one rack 102 which houses in turn a plurality of burn-in wafer shells 1, just identified herebelow with shells.

The burn-in apparatus 100, as specified in the field of application of the present invention, is arranged to carry out burn-in tests on integrated electronic circuits directly at a wafer level.

The rack 102 has a plurality of stacked housing compartments 103, in the preferred embodiment represented in the figures up to twenty-four slots, arranged to house the shells 1.

Each shell 1, which will be described in detail herebelow, is fixed on a support 5 also called *burn-in driver* or BID.

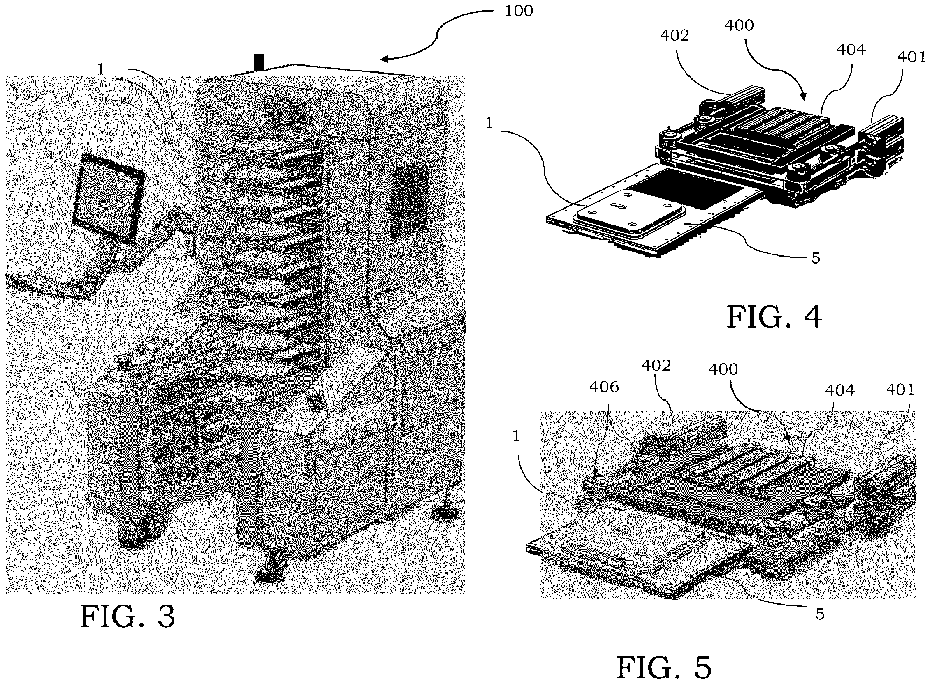

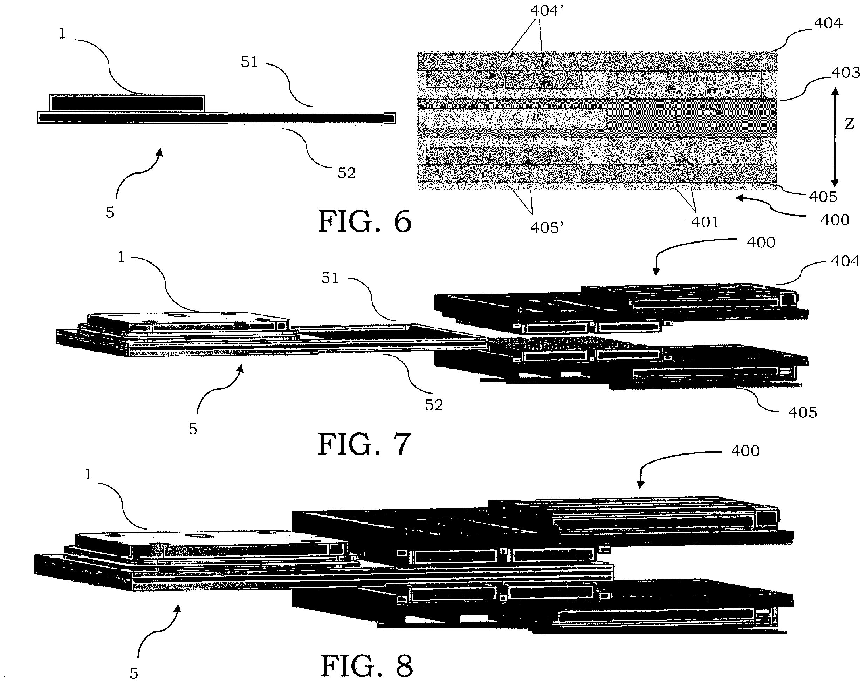

Referring now to figures 4-9, all the controls and terminals which are then transferred to the wafer W contained in the shell 1 are remoted on the BID 5. The BID 5 is provided with an upper face equipped with first electrical contacts 51 and with a lower face equipped with second electrical contacts 52.

A contact device 400, which is capable of electrically contacting the BID 5 is housed inside each chamber or slot of the burn-in apparatus 100.

The contact device 400 comprises displacement means, particularly a first actuator 401 and a second actuator 402, an intermediate housing 403, an upper contact plate 404 and a second contact plate 405.

The intermediate housing 403 is capable of housing a portion of the BID 5, when the latter is inserted into the burn-in apparatus 4.

Said first 401 and second 402 actuators are preferably of the pneumatic type. Without departing from the scope of the present invention, said first 401 and second 402 actuators can also be of the hydraulic or electrical type.

Said first 401 and second 402 actuators are connected to said intermediate housing 403 and control the movement thereof along a vertical axis Z.

In particular, said actuators 401 are laterally positioned above and below with respect to the intermediate housing 403 which is slidingly mounted along the vertical axis Z.

The actuators act on respective rotary cams 406, in the currently illustrated preferred embodiment eight in number, placed in pairs of two along the stroke of each linear actuator 401, 402.

The cams have an oblique track in which a pin or other component which is integral with the fixed structure of the rack 102 is inserted, for example directly coupled to a first contact plate 404 or to a second contact plate 405.

Said first contact plate 404 is provided with high-voltage electrical contacts 404', which are capable of contacting the first electrical contacts 51 placed on the upper face of the BID 5, to carry out high-voltage tests and, similarly, said second contact plate 405 is provided with low-voltage electrical contacts 405', which are capable of contacting the second electrical contacts 52 placed on the lower face of the BID 5, to carry out low-voltage tests.

The first electrical contacts 51 and the second electrical contacts 52 are respectively engaged when the intermediate housing 403 is in the upper end-of-stroke position or when it is in the lower end-of-stroke position.

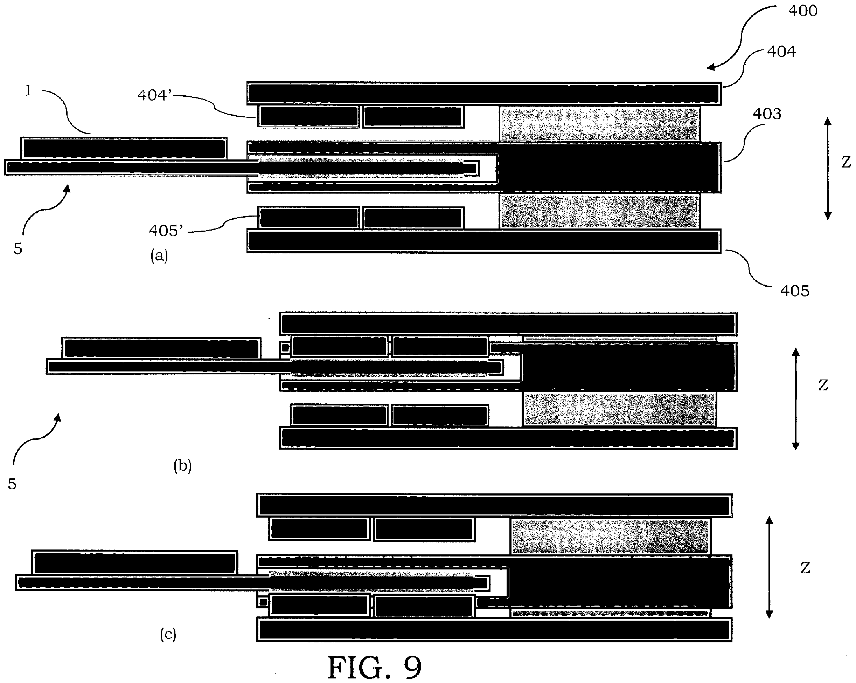

In particular, in figure 9b it is evident how the high-voltage electrical contacts 404' are in contact with the first electrical contacts 51 of the BID 5 when the intermediate housing 403 is raised, while in figure 9c it is evident how the low-voltage electrical contacts 405' are in contact with the second electrical contacts 52 of the BID 5 when the intermediate housing is lowered.

The intermediate position illustrated in figure 9a is a rest position in which the BID 5 is not electrically connected to the circuits of the rack 102.

Both said high-voltage electrical contacts 404' and said low-voltage electrical contacts 405' may consist of retractable contacts, spring contacts of the pogo-pin type. On the contrary, the first electrical contacts 51 and the second electrical contacts 52 are preferably of the fixed type.

The BID 5 has the first electrical contacts 51 and the second electrical contacts 52 in the rear portion thereof facing the chamber of the rack 102. On the contrary, the front portion of the BID 5 supports the shell 1, which houses in turn the wafer to be tested W.

The shell 1 is an assembly of components which allows the wafer W to be tested to be electrically and mechanically interfaced with the burn-in electronic board 5, and which in this case contains all the electrical resources required to carry out the burn-in test.

Moreover, the shell 1 contains the thermal power source required to bring the wafer W to the test temperature.

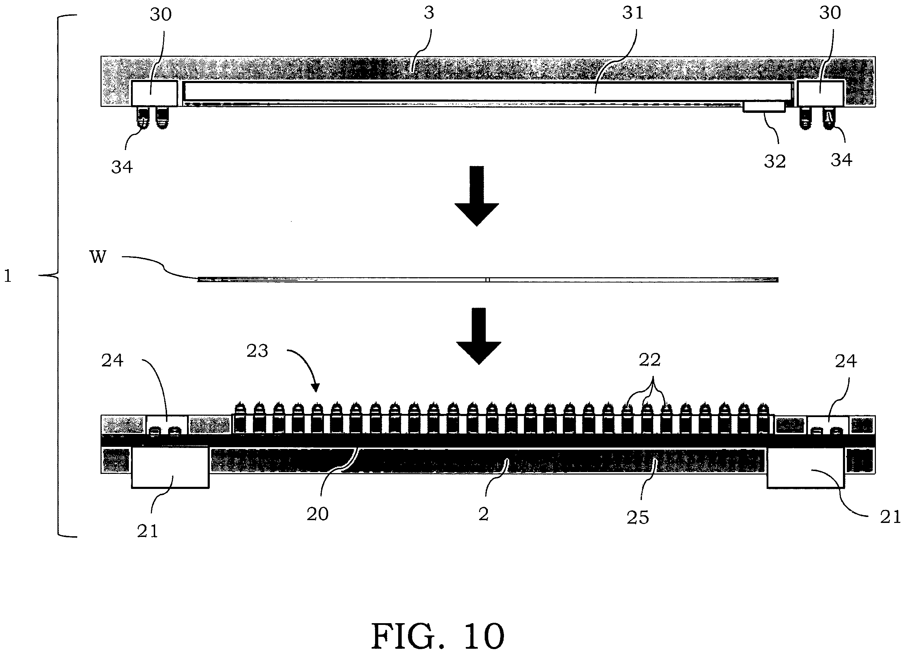

As it can be seen in figure 10, the shell comprises two mechanically and electrically coupled parts: a base 2 and a cover 3. In use, the wafer W to be tested is aligned and fixed on the cover 3, thus it is between the base 2 and the cover 3 when they are subsequently coupled.

It is noted that the terms base 2 and cover 3 do not imply any relative position between the two elements in the vertical direction.

The base 2 contains a printed circuit of the base 20 connected to a plurality of upstream electrical connectors 21 to electrically interface with the first and second electrical contacts 51, 52 of the BID 5.

A plurality of probes 22 stand from the wafer-side surface of the printed circuit of the base 20, the probes being preferably characterized by contacts of the elastic type and intended to make the electrical connection with the devices that are on the wafer W when said wafer W comes into contact with the base 2. The probes 22 may consist of retractable contacts, spring contacts of the pogo-pin type.

The above probes 22 are held in place by an assembly of mechanical components which globally take the name of probe head 23. The probe head 23 of the shell 1 according to the present invention can be preferably but not necessarily made according to the procedures described in the European Patent Application no. 22211705.3, filed in the name of the Applicant.

The base 2 also comprises, at the wafer-side surface of the printed circuit of the base 20, a plurality of downstream electrical connectors 24, being not necessarily identical to the previous ones, which couple to corresponding electrical connectors 34 of the cover 3 to allow the electrical connection between the latter and the base 2.

Moreover, the BID-side surface of the printed circuit of the base 20 is integrally fixed to a rigid frame 25 which ensures the suitable requirements of planarity of the overall assembly and also allows the mechanical fixing of the base 2 to the BID 5. This rigid frame 25, which can have different geometries and consist of one or more sub-parts, is preferably made of metal.

The cover 3 contains a heater 31, composed in particular of a heating element, which allows to bring the wafer W to the test temperature, in addition to one or more printed circuits of the cover 30 which electrically connect the heater 31 to the base through the above-mentioned electrical connectors 34 of the cover.

The cover 3 also comprises a suction system for handling and fixing the wafer W.

Although only one selected embodiment was chosen to illustrate the present invention, it will be clear to the persons skilled in the art from this disclosure that various changes and modifications can be carried out here without departing from the scope of the invention as defined in the attached claims.

## Claims

1. Burn-in apparatus (100) comprising at least one chamber to receive a wafer (W) to be tested, housed on a dedicated burn-in driver - BID (5), said chamber comprising a contact device (400) which is capable of contacting said BID (5), **characterized in that** said contact device (400) comprises a first contact plate (404), provided with electrical contacts for high-voltage tests (404'), which are capable of contacting first electrical contacts (51) of said BID (5) and a second contact plate (405), provided with electrical contacts for low-voltage tests (405'), which are capable of contacting second electrical contacts (52) of said BID (5).

2. Burn-in apparatus (100) according to the preceding claim, wherein said first contact plate (404) is positioned above with respect to said chamber and said second contact plate (405) is positioned below with respect to said chamber, or vice versa.

3. Burn-in apparatus (100) according to claim 2, **characterized in that** said contact device (400) comprises an intermediate housing (403), which is capable of integrally housing said BID (5), and displacement means (401, 402) to move said intermediate housing (403) along a vertical axis (Z), so as to put said first electrical contacts (51) or said second electrical contacts (52) of said BID in contact with said high-voltage electrical contacts (404') or with said low-voltage electrical contacts (405') respectively.

4. Burn-in apparatus (100) according to claim 3, wherein said displacement means (401, 402) consist in at least one first actuator (401) and at least one second actuator (402) which act at the opposed lateral edges of the intermediate housing.

5. Burn-in apparatus (100) according to claim 4, wherein a pair of first actuators (401), arranged above and below with respect to the intermediate housing (403), and a pair of second actuators (402), arranged above and below with respect to the intermediate housing (403), are provided.

6. Burn-in apparatus (100) according to one of claims 4 or 5, wherein said first and second actuators (401, 402) are linear actuators, arranged to rotate one or more cams (406) mounted idle on the intermediate housing (403), said cams (406) coupling with the first and/or second contact plate (404, 405), or with elements which are integral therewith, to promote the vertical movement of the intermediate housing (403) by virtue of their rotation.

7. Burn-in apparatus (100) according to one of claims 4-6, wherein said first and second actuators (401, 402) are hydraulic or pneumatic linear actuators.

8. Burn-in apparatus (100) according to any one of the preceding claims, wherein the electrical contacts for high-voltage tests (404') and the electrical contacts for low-voltage tests (404') are compliant contacts.

9. Burn-in apparatus (100) according to claim 8, wherein the electrical contacts for high-voltage tests (404') and the electrical contacts for low-voltage tests (404') are pogo-pins.

10. Burn-in apparatus (100) according to any one of the preceding claims, wherein the first electrical contacts (51) and the second electrical contacts (52) are fixed contacts.

11. Burn-in apparatus (100) according to any one of the preceding claims, wherein the first electrical contacts (51) and the second electrical contacts (52) are made on an upper surface and on a lower surface of said BID respectively, or vice versa.

12. Burn-in apparatus (100) according to claim 11, wherein the first electrical contacts (51) and the second electrical contacts (52) are made in a rear portion of the BID (5), a front portion of the BID (5) supporting instead a shell (1) for housing the wafer (W) to be tested.

13. Burn-in apparatus (100) according to claim 12, wherein said BID (5) comprises electrical connections which connect the first electrical contacts (51) and the second electrical contacts (52) to respective pads of the wafer to be tested (W) housed in said shell (1).

14. Burn-in apparatus (100) according to one of claims 12 or 13, wherein said BID (5) can be extracted with respect to the chamber according to a posterior-anterior direction.

15. Burn-in apparatus (100) according to any one of the preceding claims, comprising a rack (102) equipped with a plurality of stacked chambers.
